# EUROPEAN PATENT SPECIFICATION

(11) **EP 3 966 561 B1**
(45) Date of publication and mention of the grant of the patent: **07.01.2026**
(21) Application number: 19928189.0
(22) Date of filing: 15.05.2019
(51) Int. Cl.: G01N 27/30, C25B 11/00, H01L 21/02

(54) **USE OF AN EPITAXIAL WAFER AS A REFERENCE ELECTRODE AND ELECTROCHEMICAL SENSOR COMPRISING A REFERENCE ELECTRODE MADE OF AN EPITAXIAL WAFER**
VERWENDUNG EINES EPITAXIALWAFERS ALS REFERENZELEKTRODE UND ELEKTROCHEMISCHER SENSOR MIT EINER REFERENZELEKTRODE AUS EINEM EPITAXIALWAFER
UTILISATION D'UNE TRANCHE ÉPITAXIALE COMME ÉLECTRODE DE RÉFÉRENCE ET CAPTEUR ÉLECTROCHIMIQUE COMPRENANT UNE ÉLECTRODE DE RÉFÉRENCE FABRIQUÉE À PARTIR D'UNE TRANCHE ÉPITAXIALE

(30) Priority: 08.05.2019 CN 201910380888
(43) Date of publication of application: 16.03.2022
(73) Proprietor: Univ South China Normal, Guangzhou, Guangdong 510631 (CN)
(72) Inventor: NOTZEL, Richard, Guangzhou, Guangdong 510631 (CN)
(74) Representative: Long, Giorgio
(86) International application number: PCT/CN2019/087094
(87) International publication number: WO 2020/223995

(56) References cited:
- TW-A- 201 816 203
- US-A1- 2006 081 877
- US-A1- 2011 243 172
- NAVEED UL HASSAN ALVI ET AL: "InN/InGaN quantum dot photoelectrode: Efficient hydrogen generation by water splitting at zero voltage", NANO ENERGY, vol. 13, 1 April 2015 (2015-04-01), NL, pages 291 - 297, XP055337961, ISSN: 2211-2855, DOI: 10.1016/j.nanoen.2015.02.017
- RICHARD N�TZEL: "Review Special Topic: quantum physics and devices of quantum dots MATERIALS SCIENCE InN/InGaN quantum dot electrochemical devices: New solutions for energy and health", 20 December 2016 (2016-12-20), XP055337993, Retrieved from the Internet <URL:https://academic.oup.com/nsr/article-pdf/doi/10.1093/nsr/nww101/9235544/nww101.pdf> [retrieved on 20170123]
- PAUL E.D. SOTO RODRIGUEZ ET AL: "Electrocatalytic oxidation enhancement at the surface of InGaN films and nanostructures grown directly on Si(111)", ELECTROCHEMISTRY COMMUNICATIONS, vol. 60, 9 September 2015 (2015-09-09), NL, pages 158 - 162, XP055286402, ISSN: 1388-2481, DOI: 10.1016/j.elecom.2015.09.003
- NAVEED UL HASSAN ALVI ET AL: "An InN/InGaN Quantum Dot Electrochemical Biosensor for Clinical Diagnosis", SENSORS, vol. 13, no. 10, 15 October 2013 (2013-10-15), CH, pages 13917 - 13927, XP055286399, ISSN: 1424-8220, DOI: 10.3390/s131013917

## Description

### Technical Field

The present disclosure relates to the field of electrochemical sensors, and in particular to epitaxial wafer and a method of fabricating the same, and an electrochemical sensor.

### Background Art

Electrochemical sensors have wide application areas in medical diagnostics, environmental monitoring, food analysis, industrial process control and biodefense. A sensing electrode or transducer of an electrochemical sensor transforms a chemical signal such as a (bio-)chemical reaction or attachment of ions at the electrode surface into an electrical signal. This electrical signal is then amplified and read out on a corresponding detecting instrument to identify the concentration of an analyte of interest.

The electrode surface is often functionalized by a layer on top to turn the sensor selective for a certain (bio-) chemical reaction or a particular ion. In the case of bio-sensors, enzymes (for example glucose oxidase for the oxidation/detection of glucose for medical diagnostics) are often attached to the electrode surface. In the case of ion-sensors, ion-selective membranes are used for selective permeation of an ion of interest to specially detect a chemical reaction of the ion of interest.

Prior art documents Naveed Ul Hassan et al., "InN/InGaN quantum dot photoelectrode: Efficient hydrogen generation by water splitting at zero voltage", R. Noetzel, "Review Special Topic: quantum physics anddevices of quantum dots MATERIALS SCIENCE InN/InGaN quantum dot electrochemical devices: New solutions for energy and health", PAUL E.D. SOTO RODRIGUEZ ET AL: "Electrocatalytic oxidation enhancement at the surface of InGaN films and nanostructures grown directly on Si(111)" and NAVEED UL HASSAN ALVI ET AL: "An InN/InGaN Quantum Dot Electrochemical Biosensor for Clinica! Diagnosis" disclose an epitaxial wafer that comprises a substrate, an InGaN layer formed on a surface thereof, and an InN layer formed on a surface of the InGaN layer.

So far, according to the prior art, the reference electrode of an existing electrochemical sensor is usually a liquid-filled Ag/AgCl reference electrode or a simple but unstable solid electrode. There are no satisfactory solutions for stable all-solid-state reference electrodes to realize full all-solid-state amperometric or potentiometric electrochemical sensors.

### Summary

The objects of the present disclosure include providing a high-performance epitaxial wafer used for reference electrode which is capable of maintaining a constant electric potential in a solution, independent of the solution/analyte concentration so as to ensure accurate detection of a voltage between a working electrode and the reference electrode.

The objects of the present disclosure further include providing a reference electrode with an InGaN-based semiconductor heterostructure to replace the conventional liquid-filled Ag/AgCl electrode to implement a reference electrode with an all-solid-state structure.

In addition, the present disclosure also provides a method of fabricating an epitaxial wafer for a reference electrode of an electrochemical sensor.

According to the invention, the present disclosure provides an epitaxial wafer for a reference electrode of an electrochemical sensor, comprising: a substrate; an InGaN layer formed on a surface of the substrate and having an In content between 20% and 60% so as to ensure that a transition from negatively charged surface states to positively charged surface states occurs within a composition range; and an InN layer formed on a surface of the InGaN layer facing away from the substrate to act as a stabilization layer for a surface charge of the InGaN layer.

According to the invention, the InN layer has an InN deposition amount between 0.5 and 1.5 monolayers to ensure a surface coverage.

Optionally, the InGaN layer is a homogeneous layer with uniform In content or a heterostructure layer with varying In content of any design and morphology.

Optionally, the InGaN layer is composed of ln_{0.40}Ga_{0.60}N.

Optionally, the InGaN layer has a thickness between 100 nm and 500nm.

Optionally, a material of the substrate is one selected from sapphire, Si, SiC, and GaN.

In another aspect, the present disclosure further discloses an electrochemical sensor, comprising: a working electrode and a reference electrode made of epitaxial wafer above; a voltage detecting device electrically connected to the working electrode and the reference electrode, respectively, for detecting a voltage value between the working electrode and the reference electrode; and a computing device electrically connected to the voltage detecting device to receive a voltage value detection signal generated by the voltage detecting-device, and configured to calculate and determine the concentration of the substance to be detected based on the voltage value-

In an aspect not according to the invention, the present disclosure provides a method of fabricating an epitaxial wafer above, comprising: providing a substrate; epitaxially growing an InGaN layer on a surface of the substrate; and epitaxially growing an InN layer on a surface of the InGaN layer facing away from the substrate.

Optionally, a manner of growing the InGaN and InN layers is one selected from: molecular beam epitaxy, metalorganic vapor phase epitaxy, and chemical vapor deposition.

Optionally, the InGaN and InN layers are grown by molecular beam epitaxy.

The reference electrode made of an InGaN-based semiconductor epitaxial wafer of the present disclosure comprises at least three layers of structures, which are a substrate, an InGaN layer, and an InN layer in sequence. The InGaN layer with an In content between 20% and 60% allows a transition from negatively charged surface states to positively charged surface states so as to generate an electrochemical response independent of the concentration of the solution to be detected. The InN layer with a high density of intrinsic, positively charged surface states acts as a stabilization layer for the surface charge of the InGaN layer to further improve the electrochemical stability of the reference electrode in the present embodiment, and the combination of the InGaN layer and the InN layer further enables the reference electrode of the present embodiment to have a very stable electrochemical response.

In addition, each layer of the reference electrode of the present disclosure is of a solid-state structure, the use of a liquid-filled Ag/AgCl or similar reference electrode in the prior art is avoided, and the structure is simpler and more compact and does not have the disadvantages of liquid leakage and periodic replacement of the liquid.

In the method of fabricating the epitaxial wafer of the present disclosure, an InGaN layer and an InN layer are formed sequentially on a substrate by molecular beam epitaxy, and the formed InGaN and InN layers have uniform and very thin thickness and have extremely excellent electrochemical stability. Moreover, the fabrication method involves simple operations, and the complex processes for fabrication of the liquid-filled reference electrode in the prior art are avoided

At least one of the above and other objects, advantages and features of the present disclosure will become more apparent to those skilled in the art from the following detailed description of specific embodiments of the present disclosure with reference to accompanying drawings.

### Brief Description of Drawings

Some specific embodiments of the present disclosure will be described in detail hereinafter with reference to accompanying drawings in an exemplary but non-limiting way. The same reference numerals refer to the same or similar parts or portions in the accompanying drawings. Those skilled in the art will understand that these accompanying drawings are not necessarily drawn to scale. In the accompanying drawings:
FIG. 1 is a schematic diagram showing the entire structure of an potentiometric sensor according to an embodiment of the present disclosure;
FIG. 2a is a schematic diagram of a substrate of a multilayered structure of a epitaxial wafer according to an embodiment of the present disclosure;
FIG. 2b is a schematic diagram of growing an InGaN layer on the substrate shown in FIG. 2a;
FIG. 2c is a schematic diagram of a multilayer-structured epitaxial wafer according to an embodiment of the present disclosure;
FIG. 3 is a graph of experimental data on a fabricated reference electrode; and
FIG. 4 is a flowchart of a method of fabricating a epitaxial wafer according to an embodiment of the present disclosure.

### Detailed Description of Embodiments

Firstly, the present embodiment provides an electrochemical sensor which is mainly used for detecting the concentration of a certain substance in a solution to be detected. Among the various operation principles of electrochemical sensors, amperometric and potentiometric readouts are the most common technologies for detection of the concentration of a solution. In amperometric sensing, a current generated by an external voltage between a sensing electrode (i.e., working electrode) and a counter electrode (commonly a Pt wire or mesh) versus the voltage measured between the sensing electrode and a reference electrode, as function of the analyte concentration, is used as a detection signal. A complete amperometric sensor device, therefore, comprises a sensing electrode, a reference electrode, and a counter electrode. In potentiometric sensing, the potential difference/voltage between a sensing electrode and a reference electrode, as function of the analyte concentration, is a detection signal. A complete potentiometric sensor device, therefore, comprises a sensing electrode and a reference electrode. In amperometric sensing, the current, ideally, depends linearly on the concentration of the analyte to be detected. In potentiometric sensing, the voltage, ideally, depends linearly on the logarithm of the concentration of the analyte to be detected.

The choice of the preferred sensor solution has been extensively discussed in the literatures. The current research and development mostly focus on finding materials for highly sensitive sensing electrodes (i.e., selection of materials for working electrodes). For example, most recently, graphene, a carbon nanotube, or a semiconductor nanowire is proven to be a good material for fabrication of a working electrode.

However, currently, much less attention is paid on the reference electrode. As mentioned, both amperometric sensing and potentiometric sensing require a reference electrode to complete the function of the entire sensor device. The reference electrode is capable of providing a constant, stable potential which is independent of the analyte concentration, and it can be said that the reference electrode is a component essential for precise measurement in an electrochemical sensor.

The most widely used reference electrode is the liquid-filled Ag/AgCl electrode. It typically consists of a chlorinated Ag wire immersed in a saturated KCI solution, which is in contact with the analyte solution through a porous, inert material, such as ceramic frit or cellulose. The Ag/AgCl reference electrode establishes a complete redox cell with constant potential. Such conventional liquid-filled reference electrodes commonly have the following problems. The electrodes are bulky and difficult to miniaturize. They are not compatible with planar device fabrication technology, have a limited lifetime and need cumbersome maintenance. Therefore, the conventional liquid-filled reference electrodes need to be replaced with new technologies for realizing compact and robust electrochemical sensors and sensor arrays.

There are some solid-state electrodes at present, for example, inert noble metal wires of Au, Ag, Pt or the like are simply used as pseudo-reference electrodes, but such all-solid-state reference electrodes generally do not result in a stable response.

Another approach to realize compact all-solid-state reference electrodes is the reduction of the sensitivity of the surface of all-solid-state sensing electrodes, such as SiO2, Al2O3 or HfO2, through passivation of active sites. For passivation of active sites, e.g., silanes, PVC or polypyrroles are used. However, it is difficult to significantly reduce the sensitivity to a predictable target below 10 mV/decade of analyte concentration with desired stability or acceptable drift below 1 mV/hour in a solution with fixed analyte concentration. The overall sensor sensitivity and stability are significantly reduced when such electrodes are used as a reference electrode in a differential setup with the sensing electrode.

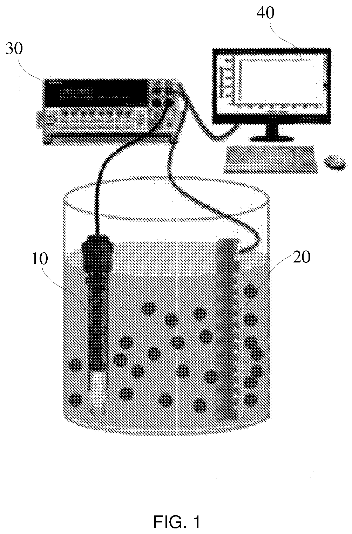

Fig.1 shows the potentiometric sensor of the present disclosure with voltmeter, the sensor generally comprises a working electrode 20 and a reference electrode 10, a voltage detecting device 30, and a computing device 40. The working electrode 20 and the reference electrode 10 are immersed in the solution to be detected, an electromotive force is generated between the working electrode 20 and the reference electrode 10, and the computing device 40 determines the concentration of the solution to be detected based on the value of the above-mentioned electromotive force.

The electrochemical reaction under study occurs on the working electrode 20. The working electrode 20 may be either solid or liquid, and various electrically conductive solid materials can be used as the electrodes. The electrochemical reaction under study is not affected by a reaction occurring in the working electrode 20 itself, and can be measured in a large potential region. The working electrode 20 must not react with the solvent or electrolyte component and should not have an excessively large area, and preferably has a surface cleaned by a simple method. In the present embodiment, an InGaN-based semiconductor composite structure may be selected and used as the working electrode 20.

The reference electrode 10 measures the relative potential of the working electrode 20. It will be described in detail hereinafter.

The voltage detecting device 30 is electrically connected to the working electrode 20 and the reference electrode 10, respectively, for detecting a voltage value between the working electrode 20 and the reference electrode 10. The voltage detecting device 30 may be any device that measures a voltage, such as a voltmeter, a multimeter, or the like. In the present embodiment, a multimeter keithley 2400 is preferred.

The computing device 40 is electrically connected to the voltage detecting device 30 to receive a voltage value detection signal generated by the voltage detecting device 30, and is configured to calculate and determine the concentration of the substance to be detected based on the voltage value. In the present embodiment, the above-mentioned computing device 40 may be a desktop computer, a laptop, or the like. In some other embodiments of the present disclosure, it may also be a small device such as a microprocessor so as to be integrated with the above-mentioned voltage detecting device 30 to form a single device.

The electrochemical sensor of the present embodiment operates based on the following principle: when the two electrodes are immersed in a solution to be detected, an electrochemical reaction for detecting the concentration of the solution occurs on the working electrode 20. The electrochemical reaction causes a charge transfer between the solution and the working electrode. This charge transfer in turn changes the surface potential of the working electrode which generates-an electromotive force between the working electrode 20 and the reference electrode 10, and the voltage detecting device 30 detects the magnitude of the above-mentioned electromotive force. In general, when the substance to be detected in the solution has a higher concentration, the electrochemical reaction is conducted more intensely, and hence a higher electromotive force is generated. In other words, the electromotive force generated between the working electrode 20 and the reference electrode 10 has a certain correspondence relationship with the concentration of the liquid to be detected, and the correspondence relationship can be expressed in the form of a function. Ideally, in voltage detection, the electromotive force depends linearly on the logarithm of the concentration of the analyte to be detected. The above function expression may be encoded into the computing device 40 in the form of a computational program, and the computing device 40 determines the value of the concentration of the substance to be detected in the solution from the magnitude of the electromotive force detected by the voltage detecting device 30.

The electrochemical sensor described above is not limited to use as a solution sensor, it could also be used in other substance, such as soil.

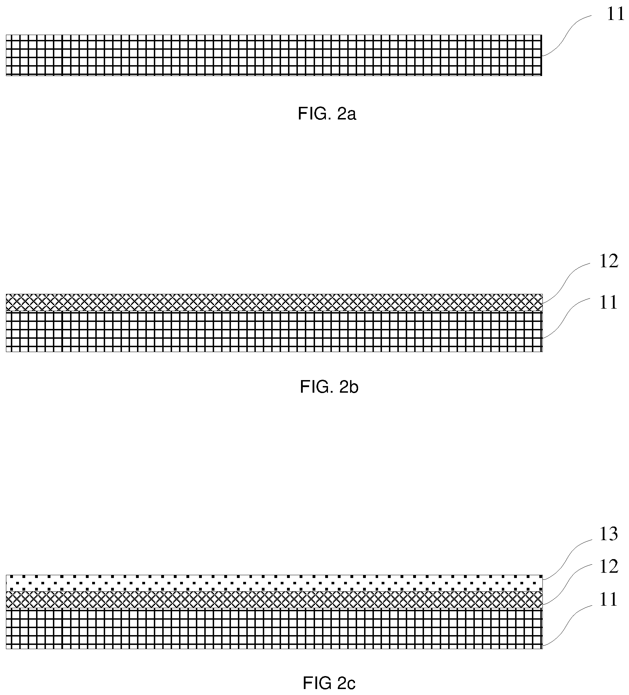

The present embodiment further provides an epitaxial wafer used for a reference electrode 10. The reference electrode 10 can be applied to the electrochemical sensor described above. It generally comprises three layers of structures, which, as shown in FIG. 2a to 2c, are a substrate 11, an InGaN layer 12, and an InN layer 13 in sequence.

Here, a material of the substrate 11 may be one selected from sapphire, Si, SiC, and GaN, and a Si substrate 11 is preferred in the present embodiment. The InGaN layer 12 is formed on a surface of the substrate 11, with an In content between 20% and 60%, so as to ensure that the transition from negatively charged surface states to positively charged surface states occurs within the composition range, thereby generating an electrochemical response independent of the concentration of the solution to be detected. The inventors have found through experiments that, as shown in Table 1, when the In content of the InGaN layer 12 is between 20% and 60%, the transition from the most negatively charged surface state to the positively charged surface state can be achieved. Preferably, an optimum transition can be achieved at an In content of 45%, which means that the reference electrode thus produced performs best. Further, as shown in Table 2, the thickness of the InGaN layer may be between 10 nm and 1 µm, preferably between 100 nm and 500 nm, and within the above range, the surface charge stability of the reference electrode is optimum.

**Table 1**

| In content of InGaN layer | Capacity to change from a negatively charged surface state to a positively charged surface state |
|---|---|
| 10% | worse |
| 20% | better |
| 45% | best |
| 60% | better |
| 80% | worse |

**Table 2**

| the thickness of InGaN | stability of surface charge |
|---|---|
| 10nm | less stable |
| 100nm | better stable |
| 300nm | best stable |
| 500nm | better stable |
| 1µm | less stable |

The InN layer 13 is formed on a surface of the InGaN layer 12 facing away from the substrate 11 to act as a stabilization layer for the surface charge of the InGaN layer 12. The InN layer 13 readily establishes a high density of intrinsic, positively charged surface states, which is tested to be up to 2 x 10¹³ cm⁻². This is the highest density of surface states among all III-V semiconductors, such that it can effectively act as a stabilization layer for the surface charge of the InGaN layer 12.

It has been experimentally found that, as shown in Table 3, the thickness of the InN layer sheet can be between 0.1 and 2 monolayer molecules, preferably 0.5 to 1.5 monolayer molecules, and the surface charge stability of the reference electrode is best within the above range. When the thickness of the InN layer exceeds 1.5 monolayers (for example, 2 monolayers), although the surface charge is relatively stable, the fabricated reference electrode will have a high response to the solution concentration. This affects the stability performance of the reference electrode, therefore the thickness of the InN layer is between 0.5 to 1.5 monolayer molecules.

**Table 3**

| the thickness of InN | stability of surface charge |
|---|---|
| 0.1 monolayers | less stable |
| 0.5 monolayers | better stable |
| 1.5 monolayers | best stable |
| 2 monolayers | stable but high response to concentration |

Used as the reference electrode 10, the epitaxial wafer with a multilayered structure described above must have stable electrical properties. In the present embodiment, firstly, the InGaN layer 12 with an In content between 20% and 60% allows a transition from negatively charged surface states to positively charged surface states so as to generate an electrochemical response independent of the concentration of the solution to be detected; and in addition, the InN layer 13 with a high density of intrinsic, positively charged surface states further improves the electrochemical stability of the reference electrode 10 in the present embodiment, and the combination of the InGaN layer 12 and the InN layer 13 further enables the reference electrode 10 of the present embodiment to have a stable electrochemical response.

Each layer of the epitaxial wafer of the present embodiment is of a solid-state structure, the use of a liquid-filled Ag/AgCl or similar reference electrode 10 in the prior art is avoided, and the structure is simpler and more compact.

Inventors carried out a relevant experiment in order to further confirm the high performance of the reference electrode which is made of epitaxial wafer described above. The reference electrode10 of the present embodiment was immersed in solution together with a conventional Ag/AgCl reference electrode. The voltage between the reference electrode and the Ag/AgCl electrode was measured. As the Ag/AgCl electrode is a perfect reference electrode, all voltage changes come from the reference electrode10 of the present embodiment to be tested for stability. The reference electrode selected and used in the experiment had an InGaN layer with an In content in the central range of the above-mentioned range values (i.e., an In content of about 40%). The InGaN layer 12 was covered with a thin InN layer 13 having a thickness between 0.5 and 1.5 monolayers. Specifically, in this experiment, a 1.5-monolayers-InN / 200-nm-In_{0.40}Ga_{0.60}N / Si(111) substrate epitaxial layer structure was selected and used as the reference electrode 10. In this experiment, KCI aqueous solutions at different concentrations were selected and used as solutions to be detected. The inventors found that the above reference electrode, when being immersed in the KCI aqueous solutions, had a stable potential measured versus an Ag/AgCl conventional electrode, which substantially did not change with the concentration of KCI.

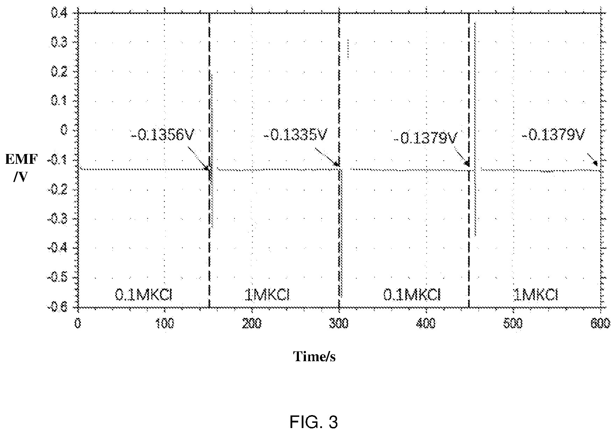

Specifically, referring to FIG. 3, the inventors further carried out an experiment where the reference electrode 10 was alternately immersed for 150 seconds in 0.1M KCI and 1M KCI aqueous solutions.

The measured voltage as a function of time exhibited an extremely slight change with the change of the concentration of the KCI solution. The response was less than 5 mV/decade of the KCI concentration change. Also the long-time drift of the voltage in a solution with fixed KCI concentration (not shown here) was below 1 mV/hour. This demonstrates the performance required for a reference electrode in electrochemical sensor devices. All these data are superior among all-solid-state electrodes attempted so far.

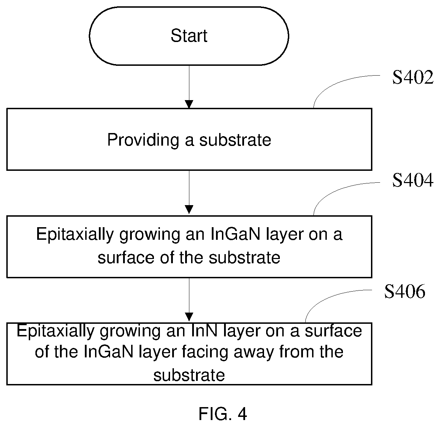

The present embodiment further provides a method of fabricating an InGaN-based electrochemical electrode epitaxial wafer. As shown in FIG. 4, it generally comprises several steps as follows:
In step S402, a substrate 11 is provided. As shown in FIG. 2a, the material of the substrate 11 may be one selected from Si, sapphire, SiC, and GaN, and a Si substrate 11 is preferred in the present embodiment. Before an InGaN layer 12 is grown epitaxially, the substrate 11 might need to be subjected to pretreatment such as ultrasonic cleaning or high-temperature heating, of which specific steps are well-known to those skilled in the art, and will not be described in detail herein.

In step S404, an InGaN layer 12 is epitaxially grown on a surface of the substrate 11. As shown in FIG. 2b, the InGaN layer 12 shown in FIG. 2b is epitaxially grown on the substrate 11. Epitaxial growth means growing, on the monocrystalline substrate 11, a monocrystalline layer meeting certain requirements and having a well defined crystallographic relationship with the substrate 11, as expanding the original wafer outwards to a certain extent. Epitaxial growth is a technology of fabricating monocrystalline thin films, which is a method of growing thin films layer by layer on the appropriate substrate 11 under suitable conditions along a direction of crystallographic axis of the material of the substrate 11. This technology has following advantages: a low temperature of the substrate 11 in use, easy and precise control over beam flux intensity, and capability of quickly adjusting components, composition and doping concentration of films and layers with variation of sources. With such technology, a monocrystalline thin film with a thickness of tens of atomic layers can be fabricated, and ultrathin layered materials with a quantum microstructure can be formed by alternately growing thin films having different components and doped with different methods. The above epitaxial growth method may be molecular beam epitaxy, metalorganic vapor phase epitaxy, or chemical vapor deposition method. The molecular beam epitaxy is an epitaxial film-making method, and is also a special vacuum coating process. The metalorganic vapor phase epitaxy and chemical vapor deposition rely on gas source transmission and pyrolysis reaction to be realized, with synthesis and decomposition taking place simultaneously. When hydrogen carries metalorganic compound vapors and non-metallic hydrides to be over the substrate 11 heated inside a reaction chamber, a series of chemical reactions take place and an epitaxial layer is generated on the substrate 11.

The InGaN structure may be a homogeneous semiconductor with uniform In content or a heterostructure with varying In content of any design and morphology, e.g., planar layer, corrugated layer, nanowall network, or nanocolumns. As to the so-called semiconductor heterostructure, semiconductor thin films of different compositions and/or different materials are deposited in sequence on the single substrate 11. Since the semiconductor heterostructure can restrict electrons and holes within an intermediate layer, its electronic properties can be tailored. In other words, in the present embodiment, the electronic properties of the InGaN layer located at an intermediate layer can be tailed so as to adjust the electrochemical response of the electrode.

As described above, the In content in InGaN is between 20% and 60% (i.e., covering the central composition range where the transition from negatively charged surface states to positively charged surface states occurs). The In content can be adjusted by a Ga-to-In flux/flow ratio. InGaN is grown at a temperature between 300 and 600 °C. The InGaN layer 12 is grown at a rate between 0.1 and 1 micrometer per hour. The final InGaN layer has a thickness between 100 nm and 500 nm.

In step S406, an InN layer 13 is epitaxially grown on a surface of the InGaN layer 12 facing away from the substrate 11. The InN layer 13 is grown in the same manner as the manner in which the InGaN layer 12 is grown. Growing the InN layer 13 follows the growth of the InGaN layer 12, after closing the Ga supply. A growth interruption can be inserted to adjust the growth conditions for the InN layer when the InN layer 13 is to be grown under different conditions from those of the InGaN layer. InN is grown at a temperature between 200 and 500 °C. The InN layer 12 is grown at a rate between 0.01 and 1 micrometer per hour. After this step, an electrochemical electrode epitaxial wafer of the reference electrode of the present disclosure is finalized.

Finally, it is necessary to fabricate an electrode from the above formed electrochemical electrode epitaxial wafer. A metal contact may be deposited on the InN layer, which is formed in a manner such as photolithography, metal deposition, or lift-off. The above metal may be Al, Au, or Ni, and preferably Ni or Au. Annealing is performed at 200 to 400 °C for 5 to 10 min for ohmic contact formation. The above layer structure is cleaved into dices of, e.g., 0.1x0.1 cm² to 1x1 cm², preferably 0.4x0.4 cm² to 6x6 cm². Metal wires are bonded to the metal contacts on the InN layer. The metal contact and wire are subsequently covered by insulating epoxy or insulating cement to fabricate a reference electrode for an electrochemical sensor.

So far, those skilled in the art will recognize that, although multiple exemplary embodiments of the present disclosure have been shown and described in a detailed way herein, many other alterations or modifications conforming to the principle of the present disclosure can be directly determined or inferred according to the contents disclosed in the present disclosure without departing from the scope of the claims. Therefore, the scope of the present disclosure should be construed and deemed as covering all of these other alterations or modifications.

## Claims

1. Use of an epitaxial wafer as a reference electrode (10) of an electrochemical sensor,
wherein the epitaxial wafer comprises:
a substrate (11);
an InGaN layer (12) formed on a surface of the substrate (11) and having an In content between 20% and 60% so as to ensure that a transition from negatively charged surface states to positively charged surface states occurs within a composition range; and
an InN layer (13) formed on a surface of the InGaN layer (12) facing away from the substrate (11) to act as a stabilization layer for a surface charge of the InGaN layer (12),
wherein the InN layer (13) has an InN deposition amount between 0.5 and 1.5 monolayers to ensure a surface coverage.

2. The use according to claim 1, wherein
the InGaN layer (12) is a homogeneous layer with uniform In content or a heterostructure layer with varying In content.

3. The use according to claim 2, wherein
the InGaN layer (12) is composed of In_{0.40}Ga_{0.60}N.

4. The use according to claim 1, wherein
the InGaN layer (12) has a thickness between 100 nm and 500 nm.

5. The use according to claim 1, wherein
a material of the substrate (11) is one selected from sapphire, Si, SiC, and GaN.

6. An electrochemical sensor, comprising:
a working electrode (20);
a reference electrode (10) made of an epitaxial wafer;
a voltage detecting device (30) electrically connected to the working electrode (20) and the reference electrode (10), respectively, for detecting a voltage value between the working electrode (20) and the reference electrode (10); and
a computing device (40) electrically connected to the voltage detecting device (30) to receive a voltage value detection signal generated by the voltage detecting device (30), and configured to calculate and determine the concentration of the substance to be-detected based on the voltage value,
wherein the epitaxial wafer comprises:
a substrate (11);
an InGaN layer (12) formed on a surface of the substrate (11) and having an In content between 20% and 60% so as to ensure that a transition from negatively charged surface states to positively charged surface states occurs within a composition range; and
an InN layer (13) formed on a surface of the InGaN layer (12) facing away from the substrate (11) to act as a stabilization layer for a surface charge of the InGaN layer (12),
wherein the InN layer (13) has an InN deposition amount between 0.5 and 1.5 monolayers to ensure a surface coverage.

7. The electrochemical sensor according to claim 6, wherein
the InGaN layer (12) is a homogeneous layer with uniform In content or a heterostructure layer with varying In content.

8. The electrochemical sensor according to claim 7, wherein
the InGaN layer (12) is composed of In_{0.40}Ga_{0.60}N.

9. The electrochemical sensor according to claim 6, wherein
the InGaN layer (12) has a thickness between 100 nm and 500 nm.

10. The electrochemical sensor according to claim 6, wherein
a material of the substrate (11) is one selected from sapphire, Si, SiC, and GaN.

## Patentansprüche

1. Verwendung eines Epitaxialwafers als Referenzelektrode (10) eines elektrochemischen Sensors, wobei der Epitaxialwafer umfasst:
ein Substrat (11);
eine InGaN-Schicht (12), die auf einer Oberfläche des Substrats (11) gebildet wird und aufweisend einen In-Gehalt zwischen 20 % und 60 %, um zu gewährleisten, dass ein Übergang von negativ geladenen Oberflächenzuständen zu positiv geladenen Oberflächenzuständen innerhalb eines Zusammensetzungsbereichs stattfindet; und
eine InN-Schicht (13), die auf einer Oberfläche der InGaN-Schicht (12) , die von dem Substrat (11) abgewandt ist, gebildet wird, um als Stabilisierungsschicht für eine Oberflächenladung der InGaN-Schicht (12) zu wirken,
wobei die InN-Schicht (13) einen InN-Abscheidungswert zwischen 0,5 und 1,5 Monolagen aufweist, um eine Oberflächenabdeckung sicherzustellen.

2. Verwendung nach Anspruch 1, wobei
die InGaN-Schicht (12) eine homogene Schicht mit gleichmäßigem In-Gehalt oder eine Heterostrukturschicht mit veränderlichem In-Gehalt ist.

3. Verwendung nach Anspruch 2, wobei
die InGaN-Schicht (12) aus In_{0,40}Ga_{0,60}N besteht.

4. Verwendung nach Anspruch 1, wobei
die InGaN-Schicht (12) eine Dicke zwischen 100 nm und 500 nm aufweist.

5. Verwendung nach Anspruch 1, wobei
ein Material des Substrats (11) ein ist, das aus Saphir, Si, SiC oder GaN ausgewählt wird.

6. Elektrochemischer Sensor, umfassend:
eine Arbeitselektrode (20);
eine Referenzelektrode (10), die aus einem Epitaxialwafer besteht;
eine Spannungserfassungsvorrichtung (30), die jeweils elektrisch mit der Arbeitselektrode (20) und der Referenzelektrode (10) verbunden ist, um einen Spannungswert zwischen der Arbeitselektrode (20) und der Referenzelektrode (10) zu erfassen; und
eine Berechnungsvorrichtung (40), die elektrisch mit der Spannungserfassungsvorrichtung (30) verbunden ist, um ein Spannungswert-Erfassungssignal zu empfangen, das von der Spannungserfassungsvorrichtung (30) erzeugt wird, und dazu konfiguriert ist, um
die Konzentration der zu erfassenden Substanz basierend auf dem Spannungswert zu berechnen und zu bestimmen,
wobei der Epitaxialwafer umfasst:
ein Substrat (11);
eine InGaN-Schicht (12), die auf einer Oberfläche des Substrats (11) gebildet wird und einen In-Gehalt zwischen 20 % und 60 % aufweist, um zu gewährleisten, dass ein Übergang von negativ geladenen Oberflächenzuständen zu positiv geladenen Oberflächenzuständen innerhalb eines Zusammensetzungsbereichs stattfindet; und
eine InN-Schicht (13), die auf einer Oberfläche der InGaN-Schicht (12), die von dem Substrat (11) abgewandt ist, gebildet wird, um als Stabilisierungsschicht für eine Oberflächenladung der InGaN-Schicht (12) zu wirken,
wobei die InN-Schicht (13) einen InN-Abscheidungswert zwischen 0,5 und 1,5 Monolagen aufweist, um eine Oberflächenabdeckung sicherzustellen.

7. Elektrochemischer Sensor nach Anspruch 6, wobei die InGaN-Schicht (12) eine homogene Schicht mit gleichmäßigem In-Gehalt oder eine Heterostrukturschicht mit veränderlichen In-Gehalt ist.

8. Elektrochemischer Sensor nach Anspruch 7, wobei die InGaN-Schicht (12) aus In_{0,40}Ga_{0,60}N besteht.

9. Elektrochemischer Sensor nach Anspruch 6, wobei die InGaN-Schicht (12) eine Dicke zwischen 100 nm und 500 nm aufweist.

10. Elektrochemischer Sensor nach Anspruch 6, wobei ein Material des Substrats (11) ein ist, das aus Saphir, Si, SiC oder GaN ausgewählt wird.

## Revendications

1. Utilisation d'une tranche épitaxiale comme électrode de référence (10) d'un capteur électrochimique, la tranche épitaxiale comprenant :
un substrat (11) ;
une couche de InGaN (12) formée sur une surface du substrat (11) et ayant une teneur en In comprise entre 20 % et 60 % de manière à garantir qu'une transition d'états de surface chargés négativement à des états de surface chargés positivement se produise dans une plage de composition ; et
une couche de InN (13) formée sur une surface de la couche de InGaN (12) tournée à l'opposé du substrat (11), agissant comme couche de stabilisation pour une charge de surface de la couche de InGaN (12),
la couche de InN (13) ayant une quantité de dépôt de InN comprise entre 0,5 et 1,5 monocouches afin d'assurer une couverture de surface.

2. L'utilisation selon la revendication 1, dans laquelle
la couche de InGaN (12) est une couche homogène avec une teneur uniforme en In ou une couche hétérostructure avec une teneur variable en In.

3. L'utilisation selon la revendication 2, dans laquelle la couche de InGaN (12) est composée de In_{0,40}Ga_{0,60}N.

4. L'utilisation selon la revendication 1, dans laquelle la couche de InGaN (12) présente une épaisseur comprise entre 100 nm et 500 nm.

5. L'utilisation selon la revendication 1, dans laquelle un matériau du substrat (11) est choisi parmi le saphir, le Si, le SiC et le GaN.

6. Capteur électrochimique, comprenant :
une électrode de travail (20) ;
une électrode de référence (10) constituée d'une tranche épitaxiale ;
un dispositif de détection de tension (30) connecté électriquement à l'électrode de travail (20) et à l'électrode de référence (10), respectivement, pour détecter une valeur de tension entre l'électrode de travail (20) et l'électrode de référence (10) ; et
un dispositif de calcul (40) connecté électriquement au dispositif de détection de tension (30) pour recevoir un signal de détection de valeur de tension généré par le dispositif de détection de tension (30), et configuré pour
calculer et déterminer la concentration de la substance à détecter sur la base de la valeur de tension,
la tranche épitaxiale comprenant :
un substrat (11) ;
une couche de InGaN (12) formée sur une surface du substrat (11) et ayant une teneur en In comprise entre 20 % et 60 % de manière à garantir qu'une transition d'états de surface chargés négativement à des états de surface chargés positivement se produise dans une plage de composition ; et
une couche de InN (13) formée sur une surface de la couche de InGaN (12) tournée à l'opposé du substrat (11), agissant comme couche de stabilisation pour une charge de surface de la couche de InGaN (12),
la couche de InN (13) ayant une quantité de dépôt de InN comprise entre 0,5 et 1,5 monocouches afin d'assurer une couverture de surface.

7. Le capteur électrochimique selon la revendication 6, dans lequel
la couche de InGaN (12) est une couche homogène avec une teneur uniforme en In ou une couche hétérostructure avec une teneur variable en In.

8. Le capteur électrochimique selon la revendication 7, dans lequel
la couche de InGaN (12) est composée de In_{0,40}Ga_{0,60}N.

9. Le capteur électrochimique selon la revendication 6, dans lequel la couche de InGaN (12) présente une épaisseur comprise entre 100 nm et 500 nm.

10. Le capteur électrochimique selon la revendication 6, dans lequel un matériau du substrat (11) est choisi parmi le saphir, le Si, le SiC et le GaN.
